# EUROPEAN PATENT APPLICATION

(11) **EP 2 858 116 A1**
(43) Date of publication of application: **08.04.2015**
(21) Application number: 13186901.8
(22) Date of filing: 01.10.2013
(51) Int. Cl.: H01L 29/786, H01L 29/66, H01L 29/40, H01L 29/417, H01L 29/423, H01L 29/16

(54) **Ambipolar transistor device and method of operating the device**

(71) Applicant: Nederlandse Organisatie voor Toegepast -Natuurwetenschappelijk Onderzoek TNO, 2628 VK Delft (NL)
(72) Inventor: Torricell, Fabrizio, 5612 AZ Eindhoven (NL); Raiteri, Daniele, 5612 AZ Eindhoven (NL)
(74) Representative: Jansen, Cornelis Marinus

(57) **Abstract**

This document describes an ambipolar transistor device comprising a semiconductor layer, a plurality of control electrodes and two or more charge transport electrodes. The charge transport electrodes include at least a source electrode and a drain electrode, and the control electrodes include a gate electrode. The charge transport electrodes are located in the device such as to be in contact with the semiconductor layer. The control electrodes are arranged such as to be electrically insulated from the semiconductor layer by an insulating layer. The control electrodes further comprise at least one auxiliary electrode, wherein the auxiliary electrode and the gate electrode are located in relation to the semiconductor layer at a same side thereof. The semiconductor layer is an ambipolar semiconductor layer comprising an ambipolar semiconductor material. The auxiliary electrode includes at least one of an auxiliary source electrode or an auxiliary drain electrode, to control for in use controlling the polarity of the ambipolar transistor by suitable charging biasing of the control electrodes such as to control charge concentrations and charge injection in said semiconductor layer.

## Description

The present invention is directed at an ambipolar transistor device comprising a semiconductor layer, a plurality of control electrodes and two or more charge transport electrodes, wherein the charge transport electrodes include at least a source electrode and a drain electrode, and wherein the control electrodes include a gate electrode, wherein the charge transport electrodes are located in the device such as to be in contact with the semiconductor layer, and wherein the control electrodes are arranged such as to be electrically insulated from the semiconductor layer by an insulating layer. The invention is further directed at a method of operating such an ambipolar transistor.

### Background

Ambipolar conduction, characterized by a superposition of electron and hole currents, has been experimentally reported in silicon and also in many non-silicon devices including carbon nanotubes, graphene, silicon nanowires, organic semiconductors, polymers, and metal-oxide semiconductors. As opposed to unipolar silicon CMOS devices whose p-type or n-type behaviour is determined during fabrication, ambipolar devices can be switched from p-type to n-type by changing the gate bias.

Depending on the bias conditions, the current in an ambipolar transistor is due to electrons, holes, or both. The operating regimes are schematically presented in figure 1 for an accumulation transistor. Throughout this document, V_{G} is the gate voltage, V_{T} the threshold voltage and V_{D} the drain voltage. All the voltages are referred to the source potential. The threshold voltage V_{T} is defined so that the transistor accumulates electrons for a gate-to-channel voltage higher than V_{T} and holes for a gate-to-channel voltage lower than V_{T}.

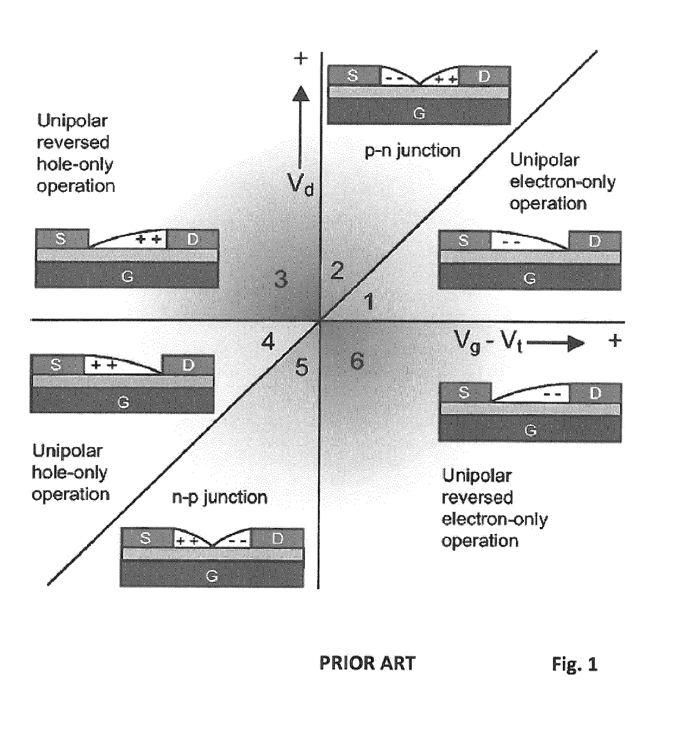

As a function of the bias at the terminals of the transistor, six different working regions can be defined that comprise electron, hole or ambipolar conduction. These six working regions are identified in figure 1 by reference numerals 1-6 for a typical conventional ambipolar transistor, and their operation conditions in terms of V_{G}, V_{T} and V_{D} are indicated in table 1 below. All these possibilities make the ambipolar transistor difficult to be operated in electronic circuits.

**Table 1**

| Regime | Bias | Transport |
|---|---|---|
| 1 | V_{G}-V_{T} > V_{D} > 0 | Electrons conduction |
| 2 | V_{D} > V_{G}-V_{T} > 0 | Ambipolar with pn-junction at the pinch-off |
| 3 | V_{G}-V_{T} < 0, V_{D} > 0 | Unipolar reversed p-type |
| 4 | 0 > V_{D} > V_{G}-V_{T} | Holes conduction |
| 5 | V_{D} < V_{G}-V_{T} < 0 | Ambipolar with pn-junction at the pinch-off |
| 6 | V_{G}-V_{T} > 0, V_{D} < 0 | Unipolar reversed n-type |

Ambipolar transistors are widely investigated for both electro-optic and circuit applications. In the case of organic ambipolar transistor, it has been shown that the light-generation efficiency of ambipolar transistors is higher than the one in organic light-emitting diodes thanks to the spatial control of the recombination zone in the transistor channel. Typical ambipolar transistor structures are staggered bottom-gate, staggered top-gate, and coplanar bottom-gate.

Ambipolar transistors are also used for electronic circuits in order to achieve a CMOS-like technology with only one semiconducting material and thus a cheaper and less complex technology. Although this idea is very appealing from a technology point of view, so far only digital inverters and ring oscillators have been demonstrated. This is due to the ambipolar mode of the transistors, which causes strong leakages that hamper the functionality of more complex circuits.

One key factor behind the success of silicon-based microelectronics is the possibility to easily develop a complementary logic. Indeed, the n-type or p-type conduction into a silicon semiconductor is obtained by means of doping. Complementary logic is of paramount importance for integrated circuits because it enables high noise margin and low power dissipation. Hence, Complementary Metal-Oxide Semiconductor (CMOS) transistors are the basic building blocks of any electronic circuit.

In many emerging electronic technologies, such as organic, graphene, and metal-oxide, the fabrication of CMOS-like circuits with p-and n-channel transistors still remains challenging. Emerging technologies make possible the fabrication of electronic circuits by means of low-temperature, large-area, high-throughput and low-cost production processes, which do not need a clean room. Substrate materials like plastic and paper are possible, thus enabling flexible, wearable, transparent, light, and green electronics. The aforementioned features are the key assets to open new applications and markets for electronic circuits.

Even if the driving forces of the emerging technologies are different with respect to the silicon technology, the availability of complementary devices still remains indispensable in order to make circuits with acceptable performance in terms of reliability, complexity and power dissipation.

On the other hand, emerging technologies usually do not offer complementary transistors because in some cases the semiconductor is intrinsically ambipolar, like graphene and carbon nanotubes, or in other cases the production process becomes more complex and thus more expensive, hence ambipolar transistors would still be preferred.

These reasons triggered a lot of attention on ambipolar transistors because they potentially offer both n- and p-type behaviour with just one semiconductor material. However, it is almost impossible to use ambipolar transistors in circuits with a reasonable complexity, since it is practically impossible to turn off the device resulting in low robustness, excessive leakage and power dissipation.

Another drawback of nowadays ambipolar transistors is that the output resistance and the intrinsic gain of the transistor degrade when it works in ambipolar mode. All these reasons prevented the large scale development of actual ambipolar analogue and digital circuits.

In order to suppress the ambipolar current, there two possible methods may be applied.

The first method relates to matching the work function of the contact electrodes with the energy bands of the semiconductor. For example, when the work function is aligned with the minimum of the conduction band, the contact is ohmic for the electrons, while a barrier of about the energy gap avoids hole injection. Analogously, aligning the work function with the maximum of the valence band, the contact becomes ohmic for holes and highly resistive (i.e. not injecting) for electrons.

This solution could be effective when the semiconductor band gap is quite large (i.e. greater then 2eV, like in organic semiconductors), but it is still quite difficult to exactly match the energetic properties of metal and semiconductor. In fact, local interface dipoles, traps, and non-idealities at the metallurgic junction can easily modify the theoretical expected barrier. Moreover, when the semiconductor affinity is small, a good electron injection requires a metal electrode with low ionization potential and hence very reactive and unstable. Because of these reasons, this method is interesting from a research point of view, but it is hardly usable for industrial applications.

The second method relates to overlapping the gate electrode with only the source. Depending on the gate potential, the source electrode can inject electrons or holes. Since the drain electrode is not overlapped with the gate electrode, it always acts as a drain (i.e. it cannot inject charge carriers of the opposite sign like in a classic ambipolar transistor).

This solution works when the semiconductor is intrinsically very conductive and hence the channel resistance is negligible with respect to the contact resistance. For example this situation is fulfilled in the case of zero-bandgap graphene. On the other hand, many semiconductors like crystalline, polycrystalline, amorphous silicon, organics and metal-oxides are quite resistive when in intrinsic state, and the non-overlapping distance between the right edge of the gate and the left edge of the drain gives rise to a high parasitic resistance which limits severely the transistor current. It is worth noting that this distance must be enough to avoid the drain contact barrier modulation by means of the fringing electric field coming from the gate edge. Moreover, it is usually difficult to control the semiconductor doping and hence the parasitic resistance, making the intrinsic drain-side of the TFT an important source of variability and mismatch.

### Summary of the Invention

It is an object of the invention to overcome the abovementioned disadvantages of the prior art solutions, and to provide a device, e.g. a thin-film transistor device, of which the polarity of the ambipolar behaviour may be effectively controlled. It is a further object to provide a method for controlling the polarity of such a device.

These and other object are achieved in that the invention provides an ambipolar transistor device comprising a semiconductor layer, a plurality of control electrodes and two or more charge transport electrodes. The charge transport electrodes include at least a source electrode and a drain electrode, and the control electrodes include a gate electrode. The charge transport electrodes are located in the device such as to be in contact with the semiconductor layer, and the control electrodes are arranged such as to be electrically insulated from the semiconductor layer by an insulating layer. The control electrodes further comprise at least one auxiliary electrode, wherein the at least one auxiliary electrode and the gate electrode are located in relation to the semiconductor layer at a same side thereof. The semiconductor layer is an ambipolar semiconductor layer comprising an ambipolar semiconductor material, and the at least one auxiliary electrode includes at least one of an auxiliary source electrode or an auxiliary drain electrode, for in use controlling the polarity of the ambipolar transistor by suitable charging of the control electrodes such as to spatially control charge concentrations in said semiconductor layer.

The ambipolar transistor device in accordance with the invention enables to choose (i.e. control) the polarity of the ambipolar transistor device to become p-only or n-only depending on electrostatic control. Using the design as proposed by the invention, a CMOS-like process can be obtained even based on standard ambipolar materials.

The invention is based on the idea to modify the charge carrier injection by means of an electric field. This electric field for modifying the charge carrier injection is generated by the at least one auxiliary electrode included by the control electrodes. This at least one auxiliary electrode is electrically insulated, i.e. no current flows to or from the at least one auxiliary electrode. Moreover, the at least one auxiliary electrode is electrostatically coupled with either the source or the drain electrode, rendering the at least one auxiliary electrode either an auxiliary source electrode or an auxiliary drain electrode respectively. As will be appreciated, in embodiments comprising more than one auxiliary electrode, some of these could be auxiliary source electrodes while others could be auxiliary drain electrodes. In a basic configuration according to an embodiment with two auxiliary electrodes, one of the auxiliary electrodes may be an auxiliary source electrode while the other may be an auxiliary drain electrode.

On the basis of the electrical potential applied to the one or more auxiliary electrodes, it is possible to inject exclusively electrons or holes from the metallic (source or drain) contact to the semiconductor. Since an ambipolar semiconductor transports both electrons and holes, the polarity of the transistor can be selected by means of the potential applied to the auxiliary electrodes.

A major advantage provided by the invention over conventional technologies, is the decoupling between the channel conductivity and the charge injection at the transport electrodes. In particular, the possibility of defining independently the carrier-type (i.e. electrons or holes) injection from the metal contact to the ambipolar semiconductor and the channel conductivity is advantageous. The invention provides the possibility to independently tune the physical process of charge injection across a metal/semiconductor interface and the field effect charge carrier density modulation in an ambipolar transistor in order to electrically define its polarity.

In an embodiment including both an auxiliary source electrode and an auxiliary drain electrode, the auxiliary source electrode, the gate electrode, and the auxiliary drain electrode may be arranged side by side in the device. This flat configuration of control electrodes in the device can be advantageously manufactured while providing excellent coupling between each of the control electrodes (auxiliary source electrode, gate electrode, auxiliary drain electrode) and the semiconductor regions under their control (central channel and accumulated regions near source and drain).

According to a further embodiment, the at least one auxiliary electrode is arranged at a level in between the semiconductor layer and the gate electrode. Although this embodiment is more difficult to manufacture, it allows to perfectly connect the central channel to the accumulated regions at the source and drain side of the transistor. Hence lower parasitic resistances may be obtained.

In accordance with yet another embodiment, the at least one auxiliary electrode comprises a single combined auxiliary source-drain electrode. In this embodiment, the gate electrode may be present in between the single combined auxiliary source-drain electrode and the semiconductor layer comprising the transport electrodes (source and drain). A further insulating layer separates the gate from the semiconductor layer. In this configuration, the potential applied to the single combined auxiliary source-drain electrode determines whether the ambipolar transistor device of the invention operates as either an n-type or a p-type channel. The ambipolar transistor works as an n-type channel when V_{BOT/TOP_S/D} > max{V_{SOURCE},V_{DRAIN}} +V_{T} and as a p-type channel when V_{BOT/TOP_S/D} < min{V_{SOURCE},V_{DRAIN}} +V_{T} (as will be appreciated, V_{BOT/TOP_S/D} is the potential applied to the single combined auxiliary source-drain electrode, V_{SOURCE} (=V_{S}) is the source potential, V_{DRAIN} (=V_{D}) is the drain potential, and V_{T} is the threshold voltage).

Further to the above, in order to provide the required coupling between the auxiliary source or drain electrodes and their respective accumulated regions near the source and drain electrodes, each one of the at least one auxiliary electrode may at least partially overlap one of the charge transport electrodes such as to form either an auxiliary source electrode or an auxiliary drain electrode.

The described ambipolar transistor device, in accordance with an embodiment, is a thin-film transistor device. The principles of the invention are very well suited to be applied in thin-film transistor technologies, such as organic, metal-oxide, or graphene thin-film transistor technologies. As will be appreciated, application of the inventive principles are not limited to only thin-film transistor technology, but may be applied more broadly.

According to a second aspect of the invention, there is provided a method of operating an ambipolar transistor comprising an ambipolar semiconductor layer comprising an ambipolar semiconductor material, a plurality of control electrodes and two or more charge transport electrodes, wherein the charge transport electrodes include at least a source electrode and a drain electrode, and wherein the control electrodes include a gate electrode and at least one auxiliary electrode, wherein the charge transport electrodes are located in the device such as to be in contact with the semiconductor layer, and wherein the control electrodes are arranged at a same side of the semiconductor layer and such as to be electrically insulated therefrom by an insulating layer, wherein the at least one auxiliary electrode includes at least one of an auxiliary source electrode or an auxiliary drain electrode; the transistor having a threshold voltage V_{T} the method comprising the step of: biasing of the source electrode at a source voltage V_{S} and biasing of the drain electrode at a drain voltage V_{D}; prior to the step of biasing of the source and drain electrodes, selectively biasing of the control electrodes such as to operate the ambipolar transistor in either an ambipolar mode or a unipolar mode.

For operating said transistor in the unipolar mode, according to an embodiment the method comprises biasing the auxiliary electrodes at a voltage V_{AUX} < (V_{CT}+V_{T}) for unipolar p-type operation or V_{AUX} > (V_{CT}+V_{T}) for unipolar n-type operation, wherein V_{CT} is the voltage Vs or V_{D} of the associated charge transport electrode.

In accordance with another embodiment, the method further comprises a step of selectively allowing an electric current to flow between the source electrode and the drain electrode by biasing the gate electrode at either a positive or negative voltage.

In accordance with another embodiment, for operating said transistor in the ambipolar mode, the method comprises charging the auxiliary electrodes at a voltage such that an auxiliary source electrode is charged at V_{AUX_S} < (V_{S}+V_{T}) and an auxiliary drain electrode is charged at V_{AUX_D} > (V_{D}+V_{T}), wherein the gate electrode is selectively operated at a positive or negative voltage to allow n-type or p-type operation.

The transistor device as defined in the first aspect may be advantageously but not exclusively be operated in accordance with a method as defined in the second aspect. However, the skilled person will appreciate that the advantages of the present invention may be obtained using other methods of operation, different voltage levels, or different materials providing similar characteristics or advantages. The invention is not limited to the embodiments described or methods applied.

### Brief description of the drawing

The invention will further be elucidated by description of some specific embodiments thereof, making reference to the attached drawings, wherein:
Figure 1 illustrates typical working regimes of a conventional type ambipolar transistor;
Figure 2 schematically illustrates a transistor in accordance with an embodiment of the invention;
Figures 3a-3d schematically illustrate the working principle of the transistor illustrated in figure 2;
Figure 4 schematically illustrates a transistor in accordance with an embodiment of the invention;
Figure 5 schematically illustrates a transistor in accordance with an embodiment of the invention in a staggered configuration;
Figure 6 schematically illustrates a transistor in accordance with an embodiment of the invention;
Figure 7 schematically illustrates a transistor in accordance with an embodiment of the invention.

### Detailed description

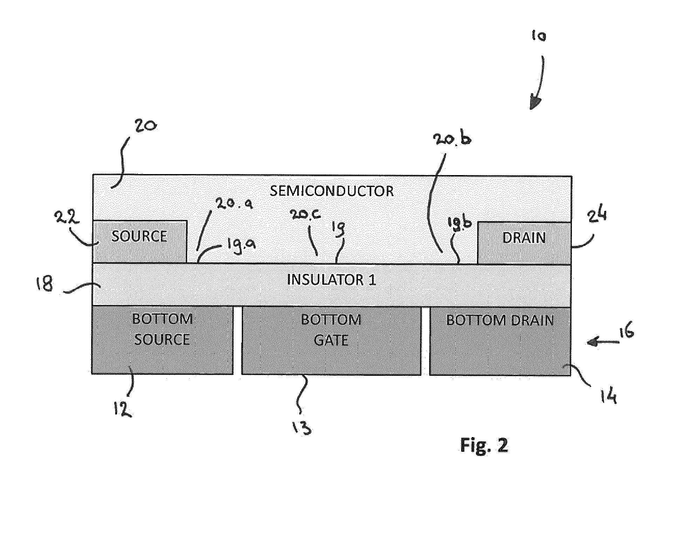

A cross-section of transistor device in accordance with an embodiment of the invention is shown in figure 2. The control electrode layer 16 of a coplanar bottom-gate thin-film transistor (TFT) 10 splits in three regions: bottom source 12, bottom gate 13 and bottom drain 14. The bottom source 12 and the bottom drain 14 respectively overlap the source 22 and drain contact 24 in order to control the charge concentration in the surrounding of the ambipolar semiconductor 20.

The operating principle of an ambipolar transistor with electrically selectable polarity, in accordance with the present invention, is described below with reference to the embodiment of figure 2. This principle may be easily extended to other structures and embodiments of the invention.

By means of a proper potential applied to the bottom source 12 and the bottom drain 14 electrodes, it is possible to electrically select the charge carriers injected from the source 22 or drain electrode 24 to the ambipolar semiconductor 20. In particular, if one type of charge carrier injection is allowed and enhanced, the other is forbidden.

The injected charge carriers are then accumulated at the insulator-semiconductor interface 19 close to the contact regions at 19a and 19b near the source 22 or drain 24. It is worth noting that the charge carriers accumulated close to the source and drain electrodes 22 and 24 behave like ohmic contacts for only one kind of charge carrier (i.e. holes or electrons). This situation mimics the common silicon metal-oxide-semiconductor field-effect transistors where heavily doped carrier-rich regions are incorporated next to the channel in order to obtain ohmic source and drain contacts.

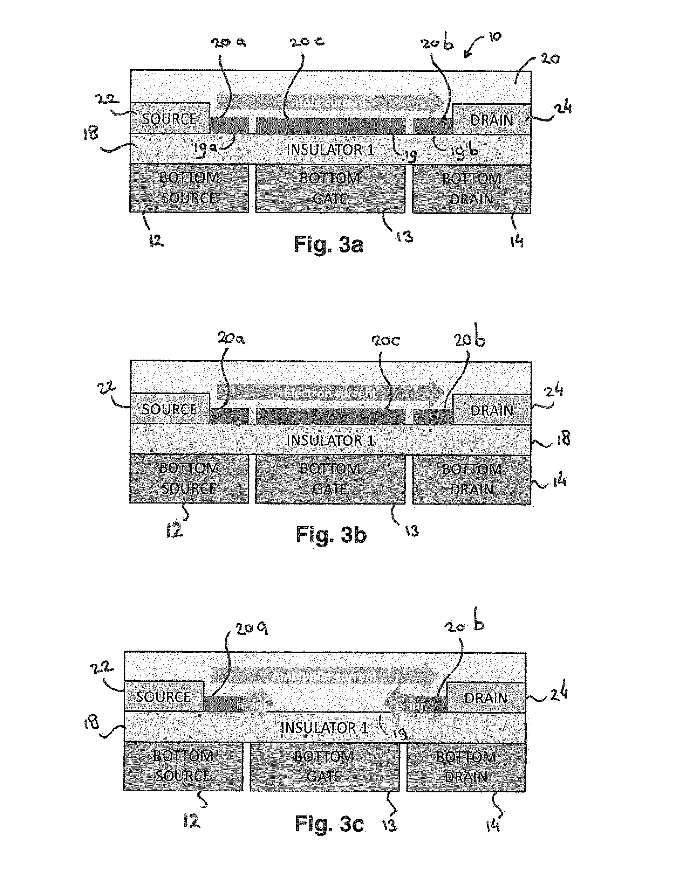

The present invention allows the selection of the type of charges injected at the source 22 and drain electrodes 24. Therefore an ambipolar TFT 10 can be operated as a p-type, n-type or ambipolar transistor by simply varying the bias at the bottom source 12 and bottom drain 14 electrodes, as illustrated in figures 3a through 3d.

In figure 3a the ambipolar TFT 10 is working as a p-type TFT. Indeed, the potential (V_{BOT-S} <V_{SOURCE}+V_{T}) applied to the bottom source 12 allows the hole-only injection, while the potential applied to the bottom drain 14 (V_{BOT-D} < V_{DRAIN} +V_{T}) inhibits the electron injection. A hole-rich layer is accumulated both at the source and at the drain side 20a and 20b and only a hole current in the transistor 10 can be modulated by the bottom gate potential of gate 13.

In figure 3b the ambipolar transistor 10 is operating in n-type mode. The operating principle is basically the same as depicted for figure 3a, but the applied potentials are reversed (i.e. multiplied by -1). The p-type operation of the ambipolar TFT 10 is guaranteed by the following condition: V_{BOT-S}<V_{SOURCE}+V_{T}, V_{BOT-D}<V_{DRAIN}+V_{T}; where V_{BOT-S} is the voltage applied to bottom source 12, V_{BOT-D} is the voltage applied to the bottom drain 14, V_{SOURCE} is the voltage applied to the source contact 22, V_{DRAIN} is the voltage applied to the drain contact 24, and V_{T} is the threshold voltage of the transistor 10. As an example V_{BOT-S}=V_{BOT-D}=-20 V, V_{BOT-GATE}= -10V.

Analogously for n-type operation must result: V_{BOT-S}>V_{SOURCE}+V_{T}, V_{BOT-D}>V_{DRAIN}+V_{T}; for example: V_{BOT-S}=V_{BOT-D}=+20 V, V_{BOT-GATE}= +10V. In practical circuit implementations V_{BOT-S} and V_{BOT-D} can be connected to the same voltage lower than the lowest circuit voltage (V_{SS}+V_{T}) to obtain p-type transistors and higher than the highest circuit voltage (V_{DD}+V_{T}) to obtain n-type transistors.

In figure 3c the TFT 10 is working in ambipolar mode. The bottom source 12 allows the holes injection while the bottom drain 14 allows the electrons injection. Depending on the potential of the bottom gate 13, the transistor current can be hole-only, electron-only or ambipolar. For example, in figure 3c, the applied potentials at the bottom source 12 and bottom drain 14 may be V_{BOT-S}=-20V and V_{BOT-D}=+20V. The potential at the bottom gate 13 may for example be V_{BOT-GATE}= -10V or +10V. This operating mode is similar to the classic ambipolar transistor.

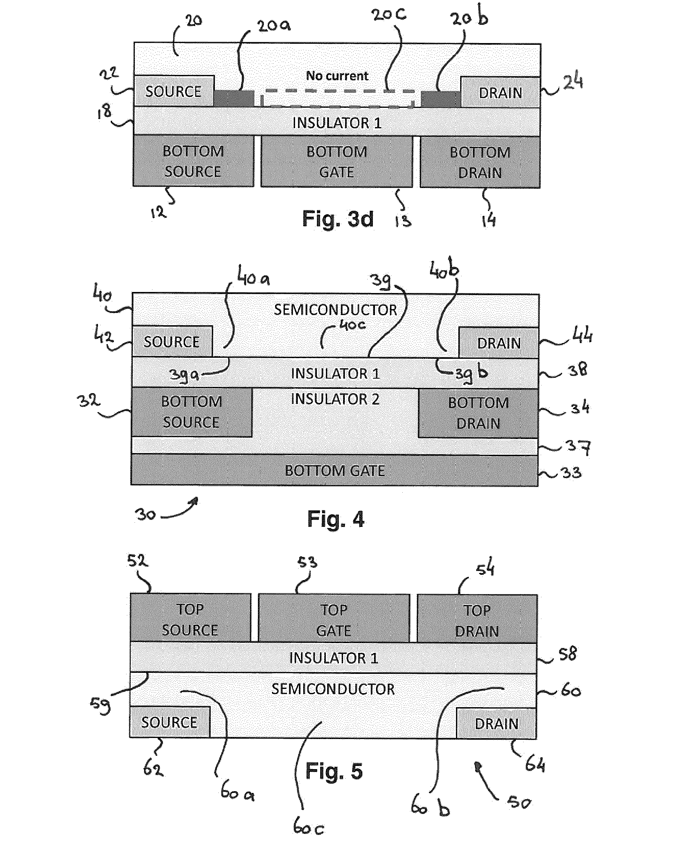

In figure 3d, the bottom source 12 and bottom drain 14 electrodes allow the electron injection only (n-type mode) while the bottom gate 13 is biased with a negative potential and hence a hole-rich channel should be expected. Since the contacts 22 and 24 cannot inject holes, the channel in semiconductor region 20c is not formed and no current can flow. Working as an n-type TFT, the transistor 10 may for example be operated with the following potentials at the bottom electrodes 12, 13 and 14: V_{BOT-S}=V_{BOT-D}=+20 V, V_{BOT-GATE}= -10V. The same holds with reversed potentials and no current is expected in the p-type mode TFT.

As will be appreciated, the values of the potentials mentioned as examples to figures 3a-3d are merely of exemplary nature, and should not be construed as limiting on the operation the transistor devices of the present invention.

Another possible embodiment of an ambipolar transistor 30 with electrically selectable polarity, in accordance with the present invention is shown in figure 4. Transistor 30 consists of source 42 and drain contact 44, located within ambipolar semiconductor layer 40. Bottom source 32 and bottom drain 34 are separated from the ambipolar semiconductor layer 40 by insulating layer 38, which in turn define a semiconductor-insulator interface layer 39. Insulator 37 separates the bottom gate 33 from the bottom source 32 and bottom drain 34. Insulator layers 37 and 38 may be separate layers or may be formed of a same insulating material, as will be appreciated by the skilled person.

The working principle of the embodiment drawn in figure 4 is basically the same as the embodiment of figure 2 and figures 3a-3d. It is worth noting that the fabrication of the transistor structure 30 in figure 4 may be more difficult then the transistor 10 in figure 2. Advantageously, however, the transistor structure 30 allows to perfectly connect the central channel 40c to the accumulated regions 40a and 40b at the source 42 and drain 44 side of the transistor. Hence lower parasitic resistances are expected.

The use of control regions electrostatically coupled with the source and drain electrodes and useful to define the polarity of an ambipolar transistor is not limited to a planar transistor structures. The invention can be implemented also in the case of staggered structures. An example of such an embodiment is illustrated in figure 5. The staggered transistor structure 50 of figure 5 has similarities with transistor device 10 shown in figures 2 and 3a-3d. Differences, however, are the 'upside down' staggering of layers and the location of source 62 and drain contact 64 in relation to the insulator-semiconductor interface 59 between insulating layer 58 and ambipolar semiconductor layer 60. Operation of the transistor 50 of figure 5 is similar to the operation of transistor device 10 described with reference to figures 3a-3d.

Although no separate illustration is included, also the embodiment of figure 4 may be implemented as a staggered structure. Again, in a staggered embodiment of the transistor illustrated in figure 4, the layers are staggered 'upside down', and the location of source and drain contact is not at the semiconductor-insulator interface but somewhere remote therefrom within the semiconductor layer (e.g. as in the transistor 50 of figure 5).

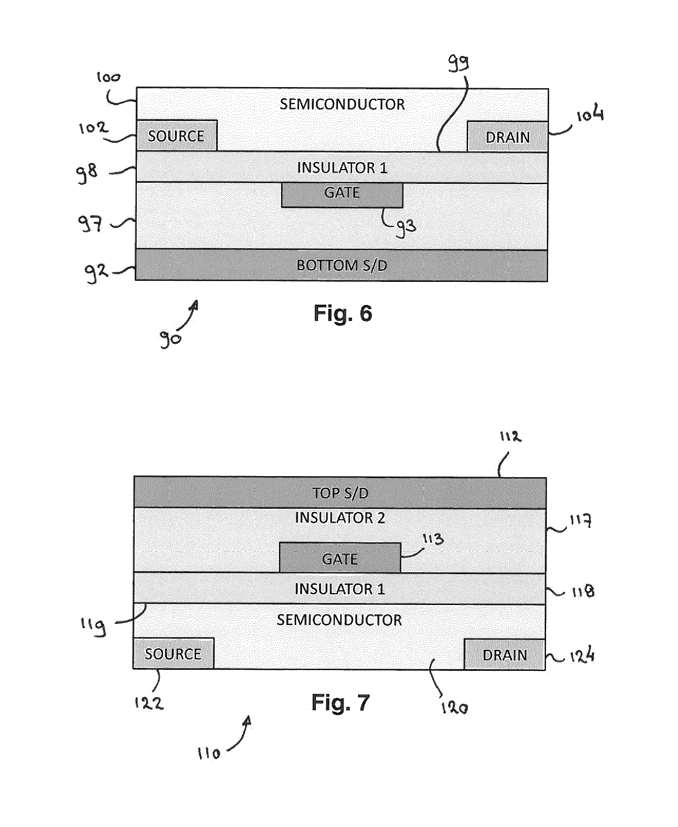

Other possible embodiments of the proposed invention are drawn in figures 6 and 7. The illustrations are mere schematic illustrations of the design: in figure 6 the bottom source and the bottom drain electrodes are combined into a single control region called bottom source/drain 92; in figure 7 the top source and the top drain regions are combined into a single conductive control region called top source/drain 112. Figure 6 illustrates a planar structure 90 and figure 7 illustrates a staggered structure 110.

Transistor 90 in figure 6 consists of source 102 and drain contact 104, located within ambipolar semiconductor layer 100. Bottom source/drain 92 is separated from the gate electrode 93 by insulating layer 97, and further separated from the ambipolar semiconductor layer 100 by insulating layer 98. An semiconductor-insulator interface layer 99 is present in between insulating layer 98 and semiconductor layer 100. Insulator layers 97 and 98 may be separate layers of different insulating material, or may be formed of a same insulating material as will be appreciated by the skilled person.

In the structure 90 of figure 6, the control of the charge injection at the source 102 and drain electrodes 104 is defined by the bottom source/drain 92. According to the description given above, the ambipolar transistor 90 of figure 6 works as an n-type channel when V_{BOT/TOP_S/D} > max{V_{SOURCE},V_{DRAIN}} +V_{T} and as a p-type channel when V_{BOT/TOP_S/D} < min{V_{SOURCE,}V_{DRAIN}} +V_{T}. The minimum channel length within ambipolar semiconductor 100 of the transistor 90 is given by the minimum extension of the "gate" region 93.

Transistor 110 in figure 7 consists of source 122 and drain contact 124, located within ambipolar semiconductor layer 120. Top source/drain 112 is separated from the gate electrode 113 by insulating layer 117, and further separated from the ambipolar semiconductor layer 120 by insulating layer 118. A semiconductor-insulator interface layer 119 is present in between insulating layer 118 and semiconductor layer 120. Insulator layers 117 and 118 may be separate layers of different insulating material, or may be formed of a same insulating material as will be appreciated by the skilled person.

In the structure 110 of figure 7, the control of the charge injection at the source 122 and drain electrodes 124 is defined by the top source/drain 112. According to the description given above, the ambipolar transistor 110 of figure 7 works as an n-type channel when V_{BOT/TOP_S/D} > max{V_{SOURCE},V_{DRAIN}} +V_{T} and as a p-type channel when V_{BOT/TOP_S/D} < min{V_{SOURCE},V_{DRAIN}} +V_{T}. The minimum channel length within ambipolar semiconductor 120 of the transistor 110 is given by the minimum extension of the "gate" region 113.

The invention particularly relates to the electrical control of the polarity of the charge carries injected from a metal electrode into an ambipolar semiconductor by means of conductive region(s) which are electrostatically coupled to the injecting electrode(s). The control regions used to define the contact injection are spatially separated and electrically insulated by the gate electrode; which can be biased with any potential. As a result, the electric potential applied to the gate region is independent of the potential bias applied to the control regions used to control the contact injection and hence the polarity of the transistor.

The invention provides a simple and effective method to electrically define the polarity of an ambipolar transistor; thus providing a CMOS-like technology with the deposition of just one semiconducting layer. This results in a simple and cheap production process, suitable for the mass production of electronic circuits.

The present invention has been described in terms of some specific embodiments thereof. It will be appreciated that the embodiments shown in the drawings and described here and above are intended for illustrative purposes only, and are not by any manner or means intended to be restrictive on the invention. The context of the invention discussed here is merely restricted by the scope of the appended claims.

## Claims

1. Ambipolar transistor device comprising a semiconductor layer, a plurality of control electrodes and two or more charge transport electrodes, wherein the charge transport electrodes include at least a source electrode and a drain electrode, and wherein the control electrodes include a gate electrode,
wherein the charge transport electrodes are located in the device such as to be in contact with the semiconductor layer, and wherein the control electrodes are arranged such as to be electrically insulated from the semiconductor layer by an insulating layer,
wherein the control electrodes further comprise at least one auxiliary electrode, wherein the at least one auxiliary electrode and the gate electrode are located in relation to the semiconductor layer at a same side thereof,
wherein the semiconductor layer is an ambipolar semiconductor layer comprising an ambipolar semiconductor material, and
wherein the at least one auxiliary electrode includes at least one of an auxiliary source electrode or an auxiliary drain electrode, for in use controlling the polarity of the ambipolar transistor by suitable biasing of the control electrodes such as to spatially control charge concentrations in said semiconductor layer.

2. Ambipolar transistor device in accordance with claim 1, wherein the at least one auxiliary electrode includes an auxiliary source electrode and an auxiliary drain electrode, wherein the auxiliary source electrode, the gate electrode, and the auxiliary drain electrode are arranged side by side in the device.

3. Ambipolar transistor device in accordance with claim 1, wherein the at least one auxiliary electrode is arranged at a level in between the semiconductor layer and the gate electrode.

4. Ambipolar transistor device in accordance with claim 1, wherein the at least one auxiliary electrode comprises a single combined auxiliary source-drain electrode.

5. Ambipolar transistor device in accordance with claim 4, wherein the gate electrode is arranged at a level in between the semiconductor layer and the single combined auxiliary source-drain electrode.

6. Ambipolar transistor device in accordance with any of the previous claims, wherein each one of the at least one auxiliary electrode at least partially overlaps one of the charge transport electrodes such as to form either an auxiliary source electrode or an auxiliary drain electrode.

7. Ambipolar transistor device in accordance with any of the previous claims, wherein said device is a thin-film transistor device.

8. Method of operating an ambipolar transistor comprising an ambipolar semiconductor layer comprising an ambipolar semiconductor material, a plurality of control electrodes and two or more charge transport electrodes, wherein the charge transport electrodes include at least a source electrode and a drain electrode, and wherein the control electrodes include a gate electrode and at least one auxiliary electrode, wherein the charge transport electrodes are located in the device such as to be in contact with the semiconductor layer, and wherein the control electrodes are arranged at a same side of the semiconductor layer and such as to be electrically insulated therefrom by an insulating layer, wherein the at least one auxiliary electrode includes at least one of an auxiliary source electrode or an auxiliary drain electrode;
the transistor having a threshold voltage VT
the method comprising the step of:
biasing of the source electrode at a source voltage VS and biasing of the source electrode at a drain voltage VD;
in addition to biasing of the source and drain electrodes, selectively biasing of the control electrodes such as to operate the ambipolar transistor in either an ambipolar mode or a unipolar mode.

9. Method according to claim 8, wherein for operating said transistor in the unipolar mode the auxiliary electrodes are biased at a voltage VAUX < (VCT+VT) for unipolar p-type operation or VAUX > (VCT+VT) for unipolar n-type operation, wherein VCT is the voltage VS or VD of the associated charge transport electrode.

10. Method according to claim 8 or 9, further comprising a step of selectively allowing an electric current to flow between the source electrode and the drain electrode by biasing the gate electrode at either a positive or negative voltage.

11. Method according to any one or more of the claims 8-10, wherein for operating said transistor in the ambipolar mode the auxiliary electrodes are biased at a voltage such that an auxiliary source electrode is biased at VAUX_S < (VS+VT) and an auxiliary drain electrode is biased at VAUX_D > (VD+VT), wherein the gate electrode is selectively operated at a positive or negative voltage to allow n-type or p-type operation.
